# EUROPEAN PATENT APPLICATION

(11) **EP 4 350 503 A1**
(43) Date of publication of application: **10.04.2024**
(21) Application number: 22819168.0
(22) Date of filing: 29.03.2022
(51) Int. Cl.: G06F 3/16, H03G 3/02, H04R 5/033, H04M 1/725

(54) **VOLUME ADJUSTMENT METHOD, AND ELECTRONIC DEVICE AND SYSTEM**

(30) Priority: 07.06.2021 CN 202110630769
(71) Applicant: Huawei Technologies Co., Ltd., Shenzhen, Guangdong 518129 (CN)
(72) Inventor: ZHU, Xiaowen, Shenzhen, Guangdong 518129 (CN)
(74) Representative: Huawei European IPR
(86) International application number: PCT/CN2022/083759
(87) International publication number: WO 2022/257563

(57) **Abstract**

Embodiments of this application provide a volume adjustment method, an electronic device, and a system. In the method in embodiments of this application, after being connected to an audio output device, an electronic device obtains type information of the audio output device, and determines different volume adjustment modes based on different type information of the audio output device, so that a user can adjust volume at different volume adjustment granularities, to improve user experience.

## Description

### TECHNICAL FIELD

This application relates to the field of electronic technologies, and in particular, to a volume adjustment method, an electronic device, and a system.

### BACKGROUND

In a related technology, there are a plurality of types of earphones, so that different audio playback requirements of a user can be met. When different types of earphones are connected to a mobile phone, volume of the earphones is controlled by using the mobile phone. When the mobile phone is connected to in-ear earphones, increasing volume of the mobile phone by one level causes the user to feel that an audio sound output by the in-ear earphones is extremely loud, and decreasing the volume by one level causes the user to feel that the audio sound is extremely low and cannot meet a requirement of the user. In a same volume adjustment mode, when the mobile phone is connected to bone conduction headphones, increasing or lowering the volume of the mobile phone by one level causes the user to feel less about a change of the audio sound.

In conclusion, when different types of earphones connected to a mobile phone are used, user experience is poor when volume is adjusted by using the mobile phone.

### SUMMARY

Embodiments of this application provide a volume adjustment method, an electronic device, and a system. Different types of volume adjustment methods may be provided based on different types of earphones, to improve user experience.

According to a first aspect, a method is provided. The method may be applied to an electronic device, and includes: establishing a connection to an audio output device; obtaining type information of the audio output device; determining a volume adjustment mode based on the type information of the audio output device; receiving a volume adjustment instruction operation; adjusting volume of a to-be-played audio based on the volume adjustment mode and the volume adjustment instruction operation; and sending the audio to the audio output device.

Different volume adjustment modes are determined based on the type information of the audio output device, so that different audio output devices correspond to different volume adjustment modes, to protect hearing of a user and improve user experience.

In a possible implementation, the obtaining type information of the audio output device is specifically: receiving the type information of the audio output device from the audio output device; or receiving a first input operation, where the first input operation includes the type information of the audio output device.

The type information of the audio input device may be entered by using the audio output device or manually by the user, to expand an application range of a supported audio output device.

In a possible implementation, the obtaining type information of the audio output device is specifically: obtaining a product model of the audio output device; and obtaining the type information of the audio output device based on the product model of the audio output device.

The product model may correspond to the type information of the audio output device, to facilitate searching for the type information of the audio output device.

In a possible implementation, the obtaining type information of the audio output device, and the determining a volume adjustment mode based on the type information of the audio output device are specifically: obtaining the type information of the audio output device and noise reduction information; and determining the volume adjustment mode based on the type information of the audio output device and the noise reduction information, where the noise reduction information indicates whether the audio output device enables a noise reduction function.

The volume adjustment mode is determined depending on whether the noise reduction function is enabled, to improve user experience.

In a possible implementation, the volume adjustment mode is a system default mode or a customized volume adjustment mode.

In a possible implementation, after the obtaining type information of the audio output device, the method further includes: outputting the type information of the device by using a pop-up window on an interface.

In a possible implementation, in the volume adjustment mode, each of a plurality of scales corresponds to different volume.

The volume of each scale is not adjusted in an even manner, so that the hearing of the user can be protected and user experience can be further improved.

In a possible implementation, the audio output device is specifically any one of headphones, in-ear earphones, ear hook headphones, bone conduction headphones, or a sounder.

In a possible implementation, a volume adjustment operation is performed by the user by using the audio output device, or by the user by using the electronic device.

In a possible implementation, the noise reduction function is enabled by the user by using the audio output device, or by the user by using the electronic device.

In a possible implementation, previewing may be performed in the customized volume adjustment mode.

In a possible implementation, the electronic device and the audio output device are connected through Bluetooth.

In a possible implementation, the electronic device is any one of a smartphone, a tablet computer, or a desktop computer.

According to a second aspect, a volume adjustment method is provided. The method is applied to an audio output device, and includes: establishing a connection to an electronic device; sending type information of the audio output device to the electronic device; receiving an audio sent by the electronic device, where the audio is determined by the electronic device based on the type information of the audio output device; and playing the audio.

In a possible implementation, the sending type information of the audio output device to the electronic device, and the receiving an audio sent by the electronic device, where the audio is determined by the electronic device based on the type information of the audio output device, are specifically: sending the type information of the audio output device and noise reduction information to the electronic device, where the noise reduction information indicates whether the audio output device enables a noise reduction function; and receiving the audio sent by the electronic device, where the audio is determined by the electronic device based on the type information of the audio output device and the noise reduction information.

In a possible implementation, the audio output device is specifically any one of headphones, in-ear earphones, ear hook headphones, bone conduction headphones, or a sounder.

In a possible implementation, a volume adjustment operation is performed by a user by using the audio output device, or by a user by using the electronic device.

In a possible implementation, the noise reduction function is enabled by a user by using the audio output device, or by a user by using the electronic device.

In a possible implementation, previewing may be performed in a customized volume adjustment mode.

In a possible implementation, the electronic device and the audio output device are connected through Bluetooth.

In a possible implementation, the electronic device is any one of a smartphone, a tablet computer, or a desktop computer.

According to a third aspect, a volume adjustment method is provided. The method is applied to a system including an audio output device and an electronic device. The electronic device is configured to perform the method in the first aspect. The audio output device is configured to perform the method in the second aspect.

According to a fourth aspect, an electronic device is provided. The electronic device includes a processor. The processor performs the method described in the first aspect by running code in a memory.

According to a fifth aspect, an audio output device is provided. The audio output device includes a processor. The processor performs the method described in the second aspect by running code in a memory.

According to a sixth aspect, a computer-readable storage medium is provided. The computer-readable storage medium includes instructions. When the instructions are run on one or more computers, the one or more computers are enabled to perform the method described in the first aspect or the second aspect.

According to a seventh aspect, a computer program product including instructions is provided. When the computer program product runs on one or more computers, the one or more computers are enabled to perform the method described in the first aspect or the second aspect.

### BRIEF DESCRIPTION OF DRAWINGS

To describe the technical solutions in embodiments of this application more clearly, the following describes the accompanying drawings used for describing embodiments of this application.
FIG. 1 is a schematic diagram of an audio communication system according to an embodiment of this application;
FIG. 2 is a schematic diagram of a plurality of forms of earphones according to an embodiment of this application;
FIG. 3A is a schematic diagram of a structure of an electronic device according to an embodiment of this application;
FIG. 3B is a schematic diagram of a structure of an audio output device according to an embodiment of this application;
FIG. 4 is a flowchart of a volume adjustment method according to an embodiment of this application; and
FIG. 5A to FIG. 5I are schematic diagrams of an interface change on an electronic device in a volume adjustment method according to an embodiment of this application.

### DESCRIPTION OF EMBODIMENTS

The following describes embodiments of the present invention with reference to the accompanying drawings in embodiments of the present invention.

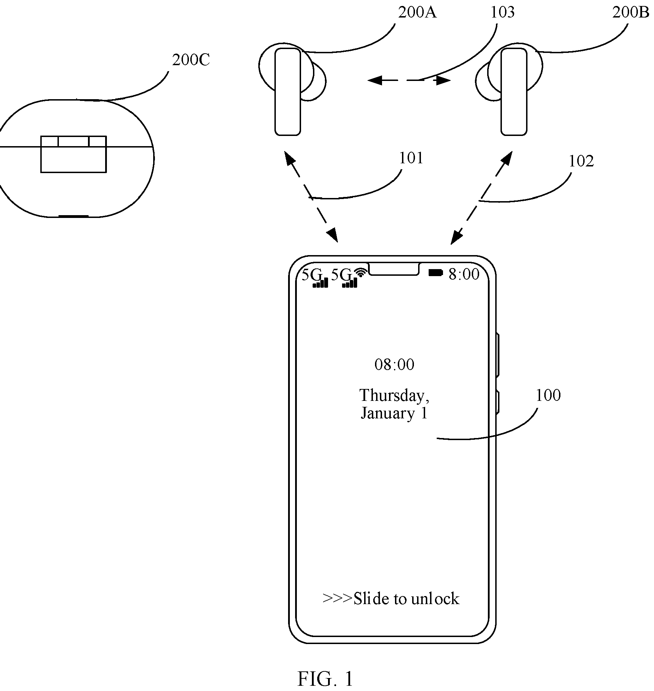

FIG. 1 shows an example of an audio system in this application. The audio system may include an electronic device 100 and earphones 200. For example, wireless earphones are used as an example in FIG. 1. In FIG. 1, the earphones 200 may include a left earphone 200A, a right earphone 200B, and an earphone case 200C. Optionally, the earphones in FIG. 1 may be wired earphones.

The left earphone 200A and the right earphone 200B may be connected without a cable. The left earphone 200A and the right earphone 200B may communicate through a wireless communication connection 103 instead of a wired communication connection. For example, the left earphone 201 and the right earphone 202 may be a left earphone and a right earphone of a pair of true wireless stereo (true wireless stereo, TWS) earphones, respectively. Optionally, the left earphone 200A and the right earphone 200B may be connected to the electronic device 100 through a cable.

In the audio system in FIG. 1, the left earphone 200A and the right earphone 200B may separately establish wireless communication connections to the electronic device 100. For example, a wireless communication connection 101 may be established between the left earphone 200A and the electronic device 100, to exchange audio data, a playback control message, a call control message, and the like through the wireless communication connection 101. Similarly, a wireless communication connection 102 may be established between the electronic device 100 and the right earphone 200B, to exchange audio data, a playback control message, a call control message, and the like through the wireless communication connection 102.

The audio system shown in FIG. 1 may be a wireless audio system implemented based on a Bluetooth protocol. To be specific, wireless communication connections between the electronic device 100, the left earphone 200A, and the right earphone 200B (for example, the wireless communication connection 101, the wireless communication connection 102, and the wireless communication connection 103) may be Bluetooth communication connections.

Not limited to Bluetooth, a communication manner between the wireless earphones 200 and the electronic device 100 may alternatively be another manner, for example, wireless fidelity (wireless fidelity, Wi-Fi), Wi-Fi direct (Wi-Fi direct), or a cellular mobile communication mode.

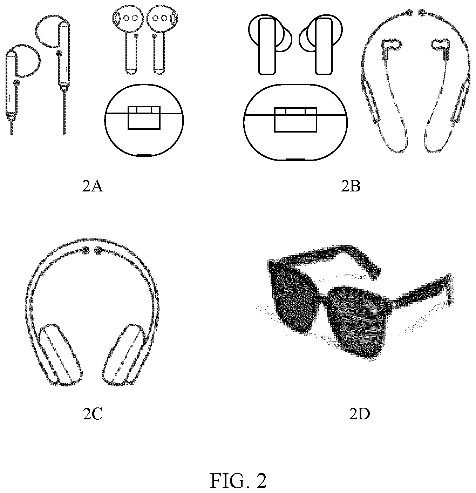

As shown in FIG. 2, the earphones 200 in this embodiment of this application may be wired or wireless ear hook headphones 2A, wired or wireless in-ear earphones 2B, wired or wireless headphones 2C, and wired or wireless bone conduction headphones 2D. It should be noted that the bone conduction headphones in FIG. 2D are a smart glasses product jointly developed by Huawei and GENTLE MONSTER^{™}. An audio is played on glasses arms in a bone conduction mode.

It should be noted that a mobile phone is used as an example of the electronic device 100 in this embodiment of this application. Alternatively, the electronic device 100 may be a watch, a tablet computer, a personal computer, or the like. This is not limited herein.

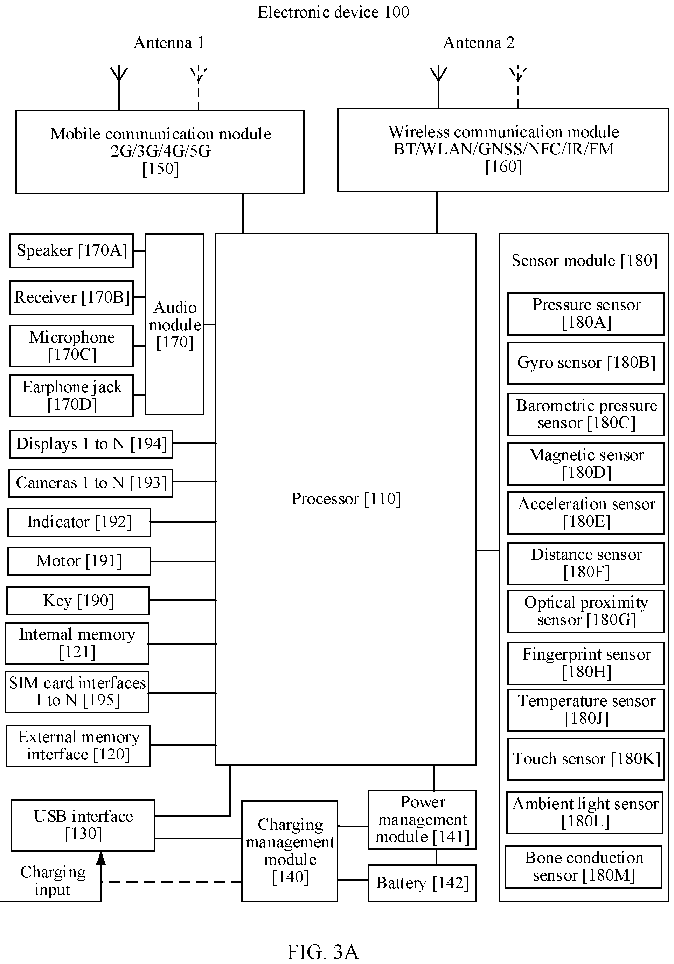

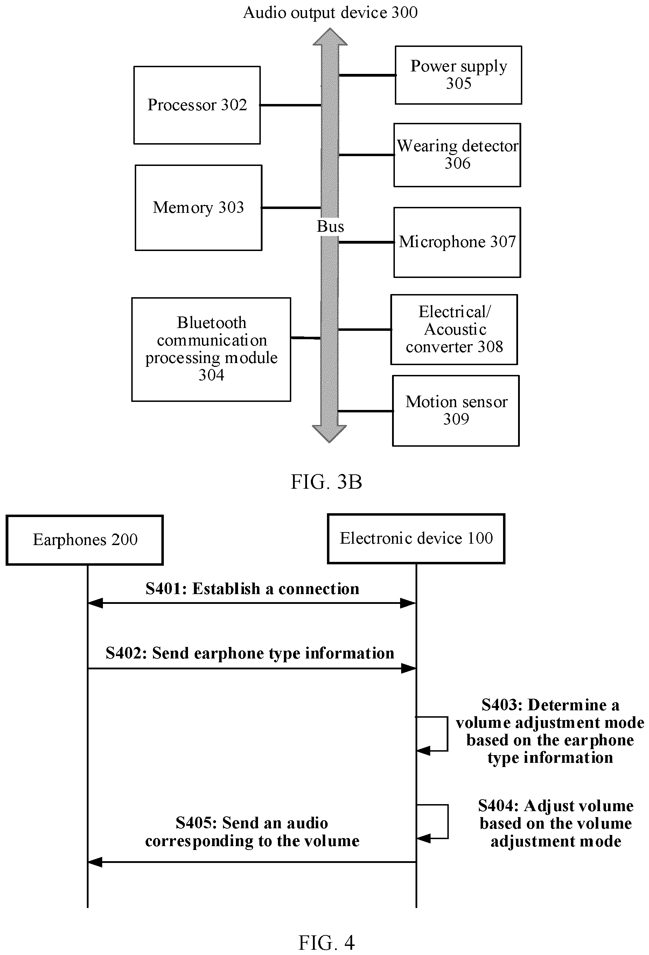

FIG. 3Ais a schematic diagram of a structure of the electronic device 100 according to an embodiment of this application.

As shown in FIG. 3A, the electronic device 100 may include a processor 110, an external memory interface 120, an internal memory 121, a universal serial bus (universal serial bus, USB) interface 130, a charging management module 140, a power management module 141, a battery 142, an antenna 1, an antenna 2, a mobile communication module 150, a wireless communication module 160, an audio module 170, a speaker 170A, a receiver 170B, a microphone 170C, an earphone jack 170D, a sensor module 180, a key 190, a motor 191, an indicator 192, a camera 193, a display 194, a subscriber identity module (subscriber identity module, SIM) card interface 195, and the like. The sensor module 180 may include a pressure sensor 180A, a gyro sensor 180B, a barometric pressure sensor 180C, a magnetic sensor 180D, an acceleration sensor 180E, a distance sensor 180F, an optical proximity sensor 180G, a fingerprint sensor 180H, a temperature sensor 180J, a touch sensor 180K, an ambient light sensor 180L, a bone conduction sensor 180M, and the like.

The processor 110 may include one or more processing units. For example, the processor 110 may include an application processor (application processor, AP), a modem processor, a graphics processing unit (graphics processing unit, GPU), an image signal processor (image signal processor, ISP), a controller, a memory, a video codec, a digital signal processor (digital signal processor, DSP), a baseband processor, and/or a neural network processing unit (neural network processing unit, NPU). Different processing units may be separate components, or may be integrated into one or more processors.

The processor may be a nerve center and a command center of the electronic device 100. The processor may generate an operation control signal based on instruction operation code and a time sequence signal to control instruction fetching and instruction execution. In this embodiment of the present invention, the processor 110 may determine a volume adjustment mode based on an obtained type of the earphones 200.

A memory configured to store instructions and data may be further disposed in the processor 110. In some embodiments, the memory in the processor 110 is a cache. The memory may store instructions or data recently used or cyclically used by the processor 110. If the processor 110 needs to use the instructions or the data again, the instructions or the data may be invoked directly from the memory. This avoids repeated access and reduces waiting time of the processor 110, to improve system efficiency.

In some embodiments, the processor 110 may include one or more interfaces. The interface may include an inter-integrated circuit (inter-integrated circuit, I2C) interface, an inter-integrated circuit sound (inter-integrated circuit sound, I2S) interface, a pulse code modulation (pulse code modulation, PCM) interface, a universal asynchronous receiver/transmitter (universal asynchronous receiver/transmitter, UART) interface, a mobile industry processor interface (mobile industry processor interface, MIPI), a general-purpose input/output (general-purpose input/output, GPIO) interface, a subscriber identity module (subscriber identity module, SIM) interface, a universal serial bus (universal serial bus, USB) interface, and/or the like.

The I2C interface is a bidirectional synchronization serial bus, and includes a serial data line (serial data line, SDA) and a serial clock line (serial clock line, SCL). In some embodiments, the processor 110 may include a plurality of sets of I2C buses. The processor 110 may be separately coupled to the touch sensor 180K, a charger, a flash, the camera 193, and the like through different I2C bus interfaces. For example, the processor 110 may be coupled to the touch sensor 180K through the I2C interface, so that the processor 110 communicates with the touch sensor 180K through the I2C bus interface, to implement a touch function of the electronic device 100.

The I2S interface may be used for audio communication. In some embodiments, the processor 110 may include a plurality of sets of I2S buses. The processor 110 may be coupled to the audio module 170 through the I2S bus, to implement communication between the processor 110 and the audio module 170. In some embodiments, the audio module 170 may transmit an audio signal to the wireless communication module 160 through the I2S interface, to implement a function of answering a call by using Bluetooth earphones.

The PCM interface may also be used for audio communication to sample, quantize, and encode an analog signal. In some embodiments, the audio module 170 and the wireless communication module 160 may be coupled through a PCM bus interface. In some embodiments, the audio module 170 may alternatively transmit an audio signal to the wireless communication module 160 through the PCM interface, to implement a function of answering a call by using Bluetooth earphones. Both the I2S interface and the PCM interface may be used for audio communication.

The UART interface is a universal serial data bus for asynchronous communication. The bus may be a bidirectional communication bus. The bus converts data to be transmitted between serial communication and parallel communication. In some embodiments, the UART interface is generally configured to connect the processor 110 to the wireless communication module 160. For example, the processor 110 communicates with a Bluetooth module in the wireless communication module 160 through the UART interface, to implement a Bluetooth function. In some embodiments, the audio module 170 may transmit an audio signal to the wireless communication module 160 through the UART interface, to implement a function of playing music by using Bluetooth earphones.

The MIPI interface may be configured to connect the processor 110 to peripheral components such as the display 194 and the camera 193. The MIPI interface includes a camera serial interface (camera serial interface, CSI), a display serial interface (display serial interface, DSI), and the like. In some embodiments, the processor 110 communicates with the camera 193 through the CSI interface, to implement a photographing function of the electronic device 100. The processor 110 communicates with the display 194 through the DSI interface, to implement a display function of the electronic device 100.

The GPIO interface may be configured by software. The GPIO interface may be configured as a control signal, or may be configured as a data signal. In some embodiments, the GPIO interface may be configured to connect the processor 110 to the camera 193, the display 194, the wireless communication module 160, the audio module 170, the sensor module 180, and the like. The GPIO interface may alternatively be configured as an I2C interface, an I2S interface, a UART interface, a MIPI interface, or the like.

The USB interface 130 is an interface that complies with a USB standard specification, and may be specifically a mini USB interface, a micro USB interface, a USB Type C interface, or the like. The USB interface 130 may be configured to connect to the charger to charge the electronic device 100, or may be configured to transmit data between the electronic device 100 and a peripheral device. The USB interface may alternatively be configured to connect to earphones, to play an audio through the earphones. The interface may be further configured to connect to another electronic device, for example, an AR device.

It may be understood that an interface connection relationship between modules shown in this embodiment of this application is merely an example for description, and does not constitute a limitation on the structure of the electronic device 100. In some other embodiments of this application, the electronic device 100 may alternatively use an interface connection mode different from that in the foregoing embodiment, or a combination of a plurality of interface connection modes.

The charging management module 140 is configured to detect charging input from the charger. The charger may be a wireless charger, or may be a wired charger. In some embodiments of wired charging, the charging management module 140 may detect a charging input from the wired charger through the USB interface 130. In some embodiments of wireless charging, the charging management module 140 may detect a wireless charging input by using a wireless charging coil of the electronic device 100. When charging the battery 142, the charging management module 140 may further supply power to the electronic device by using the power management module 141.

The power management module 141 is configured to connect the battery 142, the charging management module 140, and the processor 110. The power management module 141 detects an input from the battery 142 and/or the charging management module 140, and supplies power to the processor 110, the internal memory 121, an external memory 120, the display 194, the camera 193, the wireless communication module 160, and the like. The power management module 141 may be further configured to monitor parameters such as a battery capacity, a quantity of battery cycles, and a battery health status (leakage and impedance). In some other embodiments, the power management module 141 may alternatively be disposed in the processor 110. In some other embodiments, the power management module 141 and the charging management module 140 may alternatively be disposed in a same component.

A wireless communication function of the electronic device 100 may be implemented by using the antenna 1, the antenna 2, the mobile communication module 150, the wireless communication module 160, the modem processor, the baseband processor, and the like.

The antenna 1 and the antenna 2 are configured to transmit and detect electromagnetic wave signals. Each antenna in the electronic device 100 may be configured to cover one or more communication frequency bands. Different antennas may be further reused to improve antenna utilization. For example, the antenna 1 may be reused as a diversity antenna of a wireless local area network. In some other embodiments, the antenna may be used in combination with a tuning switch.

The mobile communication module 150 may provide a wireless communication solution that is applied to the electronic device 100 and that includes 2G/3G/4G/5G or the like. The mobile communication module 150 may include at least one filter, a switch, a power amplifier, a low noise amplifier (low noise amplifier, LNA), and the like. The mobile communication module 150 may detect an electromagnetic wave via the antenna 1, perform processing such as filtering and amplification on the detected electromagnetic wave, and transmit the electromagnetic wave to the modem processor for demodulation. The mobile communication module 150 may further amplify a signal modulated by the modem processor. The amplified signal is converted into an electromagnetic wave and radiated out via the antenna 1. In some embodiments, at least some functional modules of the mobile communication module 150 may be disposed in the processor 110. In some embodiments, at least some functional modules of the mobile communication module 150 and at least some modules of the processor 110 may be disposed in a same component.

The modem processor may include a modulator and a demodulator. The modulator is configured to modulate a low frequency baseband signal to be sent into a medium and high frequency signal. The demodulator is configured to demodulate a detected electromagnetic wave signal into a low frequency baseband signal. Then, the demodulator transmits the low frequency baseband signal obtained through demodulation to the baseband processor for processing. After being processed by the baseband processor, the low frequency baseband signal is transmitted to the application processor. The application processor outputs a sound signal through an audio output device (not limited to the speaker 170A, the receiver 170B, or the like), or displays an image or a video through the display 194. In some embodiments, the modem processor may be a separate component. In some other embodiments, the modem processor may be independent of the processor 110, and disposed in a same component as the mobile communication module 150 or another functional module.

The wireless communication module 160 may provide a wireless communication solution that is applied to the electronic device 100 and that includes a wireless local area network (wireless local area network, WLAN) (for example, a wireless fidelity (wireless fidelity, Wi-Fi) network), Bluetooth (Bluetooth, BT), a global navigation satellite system (global navigation satellite system, GNSS), frequency modulation (frequency modulation, FM), near field communication (near field communication, NFC) technology, an infrared (infrared, IR) technology, or the like. The wireless communication module 160 may be one or more components integrating at least one communication processing module. The wireless communication module 160 detects an electromagnetic wave via the antenna 2, performs frequency modulation and filtering processing on the electromagnetic wave signal, and sends a processed signal to the processor 110. The wireless communication module 160 may further detect a to-be-sent signal from the processor 110, and perform frequency modulation and amplification on the signal. An obtained signal is converted into an electromagnetic wave and radiated out via the antenna 2. For example, the wireless communication module 160 may include a Bluetooth module and a Wi-Fi module. In this embodiment of the present invention, the electronic device 100 communicates with the earphones 200 in a wireless form through the wireless communication module, and transmits an audio signal to the wireless earphones 200.

In some embodiments, in the electronic device 100, the antenna 1 and the mobile communication module 150 are coupled, and the antenna 2 and the wireless communication module 160 are coupled, so that the electronic device 100 can communicate with a network and another device by using a wireless communication technology. The wireless communication technology may include a technology, for example, a global system for mobile communications (global system for mobile communications, GSM), a general packet radio service (general packet radio service, GPRS), code division multiple access (code division multiple access, CDMA), wideband code division multiple access (wideband code division multiple access, WCDMA), time-division code division multiple access (time-division code division multiple access, TD-SCDMA), long term evolution (long term evolution, LTE), BT, a GNSS, a WLAN, NFC, FM, and/or IR. The GNSS may include a global positioning system (global positioning system, GPS), a global navigation satellite system (global navigation satellite system, GLONASS), a BeiDou navigation satellite system (BeiDou navigation satellite system, BDS), a quasi-zenith satellite system (quasi-zenith satellite system, QZSS), and/or a satellite based augmentation system (satellite based augmentation system, SBAS).

The electronic device 100 implements the display function through the GPU, the display 194, the application processor, and the like. The GPU is a microprocessor for image processing, and is connected to the display 194 and the application processor. The GPU is configured to perform mathematical and geometric calculation for graphics rendering. The processor 110 may include one or more GPUs that execute program instructions to generate or change display information.

The display 194 is configured to display an image, a video, or the like. The display 194 includes a display panel. The display panel may be a liquid crystal display (liquid crystal display, LCD), an organic light-emitting diode (organic light-emitting diode, OLED), an active-matrix organic light emitting diode (active-matrix organic light emitting diode, AMOLED), a flexible light-emitting diode (flexible light-emitting diode, FLED), a mini-LED, a micro-LED, a micro-OLED, a quantum dot light emitting diode (quantum dot light emitting diode, QLED), or the like. In some embodiments, the electronic device 100 may include one display 194 or N displays 194, where N is a positive integer greater than 1.

The electronic device 100 may implement the photographing function through the ISP, the camera 193, the video codec, the GPU, the display 194, the application processor, and the like.

The ISP is configured to process data fed back by the camera 193. For example, during photographing, a shutter is opened, light is transmitted to a photosensitive element of the camera through a lens, and an optical signal is converted into an electrical signal. The photosensitive element of the camera transmits the electrical signal to the ISP for processing, so that the ISP converts the electrical signal into an image visible to naked eyes. The ISP can further perform algorithm optimization on noise, luminance, and a skin color of the image. The ISP can further optimize parameters of a photographing scene, such as an exposure and a color temperature. In some embodiments, the ISP may be disposed in the camera 193.

The camera 193 is configured to capture a static image or a video. The lens generates an optical image for an object, and the optical image is projected to the photosensitive element. The photosensitive element may be a charge coupled device (charge coupled device, CCD) or a complementary metal-oxide-semiconductor (complementary metal-oxide-semiconductor, CMOS) phototransistor. The photosensitive element converts an optical signal into an electrical signal, and then transmits the electrical signal to the ISP to convert the electrical signal into a digital image signal. The ISP outputs the digital image signal to the DSP for processing. The DSP converts the digital image signal into an image signal in a standard format such as RGB or YUV. In some embodiments, the electronic device 100 may include one camera 193 or N cameras 193, where N is a positive integer greater than 1.

The digital signal processor is configured to process a digital signal, and may process another digital signal in addition to the digital image signal. For example, when the electronic device 100 selects a frequency, the digital signal processor is configured to perform Fourier transform on energy of the frequency.

The video codec is configured to compress or decompress a digital video. The electronic device 100 may support one or more video codecs. In this way, the electronic device 100 may play or record videos in a plurality of encoding formats, for example, moving picture experts group (moving picture experts group, MPEG) 1, MPEG 2, MPEG 3, and MPEG 4.

The NPU is a neural network (neural network, NN) computing processor. With reference to a structure of a biological neural network, for example, with reference to a transmission mode between human brain neurons, the NPU quickly processes input information, and can continuously perform self-learning. The NPU may be used to implement an application such as intelligent cognition of the electronic device 100, for example, image recognition, facial recognition, speech recognition, and text understanding.

The external memory interface 120 may be configured to connect to an external memory card, such as a micro SD card, to expand a storage capability of the electronic device 100. The external memory card communicates with the processor 110 through the external memory interface 120, to implement a data storage function. For example, a file such as music or a video is stored on the external memory card.

The internal memory 121 may be configured to store computer executable program code. The executable program code includes instructions. The internal memory 121 may include a program storage area and a data storage area. The program storage area may store an operating system, an application required by at least one function (for example, a sound playback function or an image playback function), and the like. The data storage area may store data (for example, audio data or an address book) created in a process of using the electronic device 100, and the like. In addition, the internal memory 121 may include a high-speed random access memory, and may further include a nonvolatile memory, such as at least one magnetic disk storage component, a flash memory, or a universal flash storage (universal flash storage, UFS). The processor 110 executes various functional applications and data processing of the electronic device 100 by running the instructions stored in the internal memory 121 and/or the instructions stored in the memory disposed in the processor.

The electronic device 100 may implement an audio function, such as music playback or recording by using the audio module 170, the speaker 170A, the receiver 170B, the microphone 170C, the earphone jack 170D, the application processor, and the like.

The audio module 170 is configured to convert digital audio information into an analog audio signal for output, and is further configured to convert an analog audio input into a digital audio signal. The audio module 170 may be further configured to encode and decode an audio signal. In some embodiments, the audio module 170 may be disposed in the processor 110, or some functional modules of the audio module 170 may be disposed in the processor 110.

The speaker 170A, also referred to as a "horn", is configured to convert an audio electrical signal into a sound signal. The electronic device 100 may be used to listen to music or listen to a hands-free call by using the speaker 170A.

The receiver 170B, also referred to as an "earpiece", is configured to convert an audio electrical signal into a sound signal. When the electronic device 100 is used to answer a call or listen to voice information, the receiver 170B may be placed close to a human ear to listen to a voice.

The microphone 170C, also referred to as a "mike" or a "mic", is configured to convert a sound signal into an electrical signal. When making a call or sending voice information, a user may place the microphone 170C close to a human mouth and make a sound, to input a sound signal to the microphone 170C. At least one microphone 170C may be disposed in the electronic device 100. In some other embodiments, two microphones 170C may be disposed in the electronic device 100. In addition to collecting a sound signal, the microphones may further implement a noise reduction function. In some other embodiments, three, four, or more microphones 170C may be disposed in the electronic device 100, to collect a sound signal, reduce noise, identify a sound source, implement a directional recording function, and the like.

The earphone jack 170D is configured to connect wired earphones. The earphone jack 170D may be the USB interface 130, or may be a 3.5 mm open mobile terminal platform (open mobile terminal platform, OMTP) standard interface, a cellular telecommunications industry association of the USA (cellular telecommunications industry association of the USA, CTIA) standard interface, or a lighting interface. The electronic device 100 may be connected to the earphones 200 in a wired form through the earphone jack 170D, and transmit an audio signal.

The pressure sensor 180A is configured to sense a pressure signal, and may convert the pressure signal into an electrical signal. In some embodiments, the pressure sensor 180A may be disposed on the display 194. There are many types of pressure sensors 180A, such as a resistive pressure sensor, an inductive pressure sensor, and a capacitive pressure sensor. The capacitive pressure sensor may include at least two parallel plates with conducting materials. When a force is applied to the pressure sensor 180A, capacitance between electrodes changes. The electronic device 100 determines a pressure intensity based on the capacitance change. When a touch operation is performed on the display 194, the electronic device 100 detects an intensity of the touch operation based on the pressure sensor 180A. The electronic device 100 may further calculate a touch location based on a detection signal of the pressure sensor 180A. In some embodiments, touch operations that are performed at a same touch location but have different touch operation intensities may correspond to different operation instructions. For example, when a touch operation whose touch operation intensity is less than a first pressure threshold is performed on an SMS message application icon, an instruction for viewing an SMS message is executed. When a touch operation whose touch operation intensity is greater than or equal to the first pressure threshold is performed on the SMS message application icon, an instruction for creating an SMS message is executed.

The gyro sensor 180B may be configured to determine a motion posture of the electronic device 100. In some embodiments, angular velocities of the electronic device 100 around three axes (that is, x, y, and z axes) may be determined by using the gyro sensor 180B. The gyro sensor 180B may be used for image stabilization during photographing. For example, when the shutter is opened, the gyro sensor 180B detects a shake angle of the electronic device 100, calculates, based on the angle, a distance that needs to be compensated for by a lens module, and enables the lens to counteract the shake of the electronic device 100 by performing reverse motion, to implement image stabilization. The gyro sensor 180B may be further used for navigation and motion sensing games.

The barometric pressure sensor 180C is configured to measure barometric pressure. In some embodiments, the electronic device 100 calculates an altitude based on a barometric pressure value measured by the barometric pressure sensor 180C, to assist in positioning and navigation.

The magnetic sensor 180D includes a Hall sensor. The electronic device 100 may detect opening and closing of a flip leather case by using the magnetic sensor 180D. In some embodiments, when the electronic device 100 is a clamshell phone, the electronic device 100 may detect opening and closing of a flip cover based on the magnetic sensor 180D. Then, based on a detected opening or closing status of the leather case or a detected opening or closing status of the flip cover, a feature such as automatic unlocking upon opening of the flip cover is set.

The acceleration sensor 180E may detect magnitudes of acceleration of the electronic device 100 in various directions (generally on three axes). A magnitude and a direction of gravity may be detected when the electronic device 100 is stationary. The acceleration sensor 180E may be further configured to identify a posture of the electronic device, to be applied to applications such as landscape/portrait switching and a pedometer.

The distance sensor 180F is configured to measure a distance. The electronic device 100 may measure a distance by using infrared light or a laser. In some embodiments, in a photographing scene, the electronic device 100 may measure a distance by using the distance sensor 180F, to implement fast focusing.

The optical proximity sensor 180G may include, for example, a light emitting diode (LED) and a light detector such as a photodiode. The light emitting diode may be an infrared light emitting diode. The electronic device 100 emits infrared light outwards by using the light emitting diode. The electronic device 100 detects infrared reflected light from a nearby object by using the photodiode. When detecting adequate reflected light, the electronic device 100 may determine that there is an object near the electronic device 100. When detecting inadequate reflected light, the electronic device 100 may determine that there is no object near the electronic device 100. The electronic device 100 may detect, by using the optical proximity sensor 180G, that the user holds the electronic device 100 close to the ear for a call, to automatically turn off the screen to save power. The optical proximity sensor 180G may be further used for automatic unlocking or locking in a leather case mode and a pocket mode.

The ambient light sensor 180L is configured to sense ambient light luminance. The electronic device 100 may adaptively adjust luminance of the display 194 based on the sensed ambient light luminance. The ambient light sensor 180L may be further configured to automatically adjust white balance during photographing. The ambient light sensor 180L may further corporate with the optical proximity sensor 180G to detect whether the electronic device 100 is in a pocket, to prevent accidental touch.

The fingerprint sensor 180H is configured to collect a fingerprint. The electronic device 100 may implement fingerprint-based unlocking, access to an application lock, fingerprint photographing, fingerprint answering, and the like by using a feature of the collected fingerprint.

The temperature sensor 180J is configured to detect a temperature. In some embodiments, the electronic device 100 executes a temperature processing policy by using the temperature detected by the temperature sensor 180J. For example, when the temperature reported by the temperature sensor 180J exceeds a threshold, the electronic device 100 reduces performance of a processor located near the temperature sensor 180J, to reduce power consumption and implement heat protection. In some other embodiments, when the temperature is lower than another threshold, the electronic device 100 heats the battery 142, to avoid abnormal shutdown of the electronic device 100 caused by a low temperature. In some other embodiments, when the temperature is lower than still another threshold, the electronic device 100 increases an output voltage of the battery 142, to avoid abnormal shutdown caused by a low temperature.

The touch sensor 180K is also referred to as a "touch panel". The touch sensor 180K may be disposed on the display 194. A touchscreen formed by the touch sensor 180K and the display 194 is also referred to as a "touch screen". The touch sensor 180K is configured to detect a touch operation performed on or near the touch sensor. The touch sensor may transmit the detected touch operation to the application processor, to determine a touch event type. A visual output related to the touch operation may be provided by using the display 194. In some other embodiments, the touch sensor 180K may alternatively be disposed on a surface of the electronic device 100, and at a location different from that of the display 194.

The bone conduction sensor 180M may obtain a vibration signal. In some embodiments, the bone conduction sensor 180M may obtain a vibration signal of a vibrating bone block of a vocal part of a human body. The bone conduction sensor 180M may further contact with a pulse of the human body and detect a blood pressure pulse signal. In some embodiments, the bone conduction sensor 180M may alternatively be disposed in earphones, to form bone conduction headphones. The audio module 170 may parse out a voice signal based on the vibration signal that is of the vibrating bone block of the vocal part and that is obtained by the bone conduction sensor 180M, to implement a voice function. The application processor may parse heart rate information based on the blood pressure pulse signal obtained by the bone conduction sensor 180M, to implement a heart rate detection function.

The key 190 includes a power key, a volume key, or the like. The key 190 may be a mechanical key, or may be a touch key. The electronic device 100 may detect a key input, and generate a key signal input related to a user setting and function control of the electronic device 100.

The motor 191 may generate a vibration alert. The motor 191 may be configured to generate a vibration alert for an incoming call, or generate a vibration feedback for a touch operation. For example, touch operations performed on different applications (for example, photographing and audio playback) may correspond to different vibration feedback effects. The motor 191 may further enable touch operations performed on different areas of the display 194 to correspond to different vibration feedback effects. Different application scenarios (for example, a time reminder, information detecting, an alarm clock, and a game) may also correspond to different vibration feedback effects. A vibration feedback effect for a touch operation can alternatively be customized.

The indicator 192 may be an indicator light, may be configured to indicate a charging status and a power change, and may also be configured to indicate a message, a missed call, a notification, or the like.

The SIM card interface 195 is configured to connect to a SIM card. The SIM card may be inserted into the SIM card interface 195 or removed from the SIM card interface 195, to implement contact with or separation from the electronic device 100. The electronic device 100 may support one SIM card interface or N SIM card interfaces, where N is a positive integer greater than 1. The SIM card interface 195 may support a nano SIM card, a micro SIM card, a SIM card, and the like. A plurality of cards may be inserted into a same SIM card interface 195. The plurality of cards may be of a same type or of different types. The SIM card interface 195 is also compatible with different types of SIM cards. The SIM card interface 195 is also compatible with an external memory card. The electronic device 100 interacts with a network through the SIM card, to implement functions such as a call and data communication. In some embodiments, the electronic device 100 uses an eSIM, that is, an embedded SIM card. The eSIM card may be embedded in the electronic device 100, and cannot be separated from the electronic device 100.

The foregoing describes in detail this embodiment of this application by using the electronic device 100 as an example. It should be understood that the structure shown in this embodiment of this application does not constitute a specific limitation on the electronic device 100. The electronic device 100 may have more or fewer components than those shown in the figure, may combine two or more components, or may have different component configurations. Various components shown in the figure may be implemented in hardware that includes one or more signal processors and/or application-specific integrated circuits, software, or in a combination of hardware and software.

FIG. 3B is a schematic diagram of a structure of the earphones 200 according to an embodiment of this application.

An audio output device 300 may be the left earphone 200A or the right earphone 200B of the earphones 200 shown in FIG. 1, and may convert audio data from an audio source (such as a smartphone) into a sound. In some scenarios, if a sound collection component such as a microphone/receiver is disposed, the audio output device 300 may also be used as an audio source to transmit audio data (for example, audio data converted from a voice of a user that is collected by earphones) to another device (such as a mobile phone).

FIG. 3B shows an example of a schematic diagram of a structure of the audio output device 300 according to an embodiment of this application. As shown in FIG. 3B, the audio output device 300 may include a processor 302, a memory 303, a Bluetooth communication processing module 304, a power supply 305, a wearing detector 306, a microphone 307, an electrical/acoustic converter 308, and a motion sensor 309. These components may be connected through a bus.

The processor 302 may be configured to read and execute computer readable instructions. During specific implementation, the processor 302 may mainly include a controller, an arithmetic unit, and a register. The controller is mainly responsible for instruction decoding, and sends a control signal for an operation corresponding to the instruction. The arithmetic unit is mainly responsible for performing a fixed-point or floating-point arithmetic operation, a shift operation, a logic operation, and the like, and may also perform an address operation and conversion. The register is mainly responsible for storing a register operand, an intermediate operation result, and the like that are temporarily stored during instruction execution. During specific implementation, a hardware architecture of the processor 302 may be an application-specific integrated circuit (Application-Specific Integrated Circuit, ASIC) architecture, an MIPS architecture, an ARM architecture, an NP architecture, or the like.

In some embodiments, the processor 302 may be configured to parse a signal detected by the Bluetooth communication processing module 304, for example, a signal encapsulated with audio data, a content control message, or a flow control message. The processor 302 may be configured to perform a corresponding processing operation based on a parsing result, for example, drive the electrical/acoustic converter 308 to start, temporarily stop, or stop converting the audio data into a sound.

In some embodiments, the processor 302 may be further configured to generate a signal to be sent by the Bluetooth communication processing module 304 to the outside, for example, a Bluetooth broadcast signal or a beacon signal, or audio data converted from a collected sound.

The memory 303 is coupled to the processor 302, and is configured to store various software programs and/or a plurality of sets of instructions. During specific implementation, the memory 303 may include a high-speed random access memory, and may further include a non-volatile memory, for example, one or more disk storage devices, flash storage devices, or other non-volatile solid-state storage devices. The memory 303 may store an operating system, for example, an embedded operating system such as uCOS, VxWorks, or RTLinux. The memory 303 may further store a communication program. The communication program may be configured to communicate with the electronic device 100, one or more servers, or an additional device.

The Bluetooth (BT) communication processing module 304 may detect a signal transmitted by another device (for example, the electronic device 100), for example, a scanning signal, a broadcast signal, a signal encapsulated with audio data, a content control message, or a flow control message. The Bluetooth (BT) communication processing module 304 may also transmit a signal, for example, a broadcast signal, a scanning signal, a signal encapsulated with audio data, a content control message, or a flow control message.

The power supply 305 may be configured to supply power to other internal components such as the processor 302, the memory 303, the Bluetooth communication processing module 304, the wearing detector 306, and the electrical/acoustic converter 308.

The wearing detector 306 may be configured to detect a status indicating whether the audio output device 300 is worn by a user, for example, a non-worn status or a worn status, or even a wearing tightness status. In some embodiments, the wearing detector 306 may be implemented by one or more of a distance sensor, a pressure sensor, and the like. The wearing detector 306 may transmit the detected wearing status to the processor 302. In this way, the processor 302 can be powered on when the audio output device 300 is worn by the user, and powered off when the audio output device 300 is not worn by the user, to reduce power consumption.

The motion sensor 309 may be configured to detect a motion posture of the earphones, may include a gyro sensor, an accelerometer sensor, a magnetic field detection sensor, and the like, and may collect, for example, a rotation value (for example, a rotation direction or a rotation angle) and a movement value (for example, acceleration or a displacement) in each direction.

The microphone 307 may be configured to collect a sound, for example, a voice of the user, and may output the collected sound to the electrical/acoustic converter 308. In this way, the electrical/acoustic converter 308 may convert the sound collected by the microphone 307 into audio data.

The electrical/acoustic converter 308 may be configured to convert a sound into an electrical signal (audio data), for example, convert the sound collected by the microphone 307 into the audio data, and may transmit the audio data to the processor 302. In this way, the processor 302 may trigger the Bluetooth (BT) communication processing module 304 to transmit the audio data. The electrical/acoustic converter 308 may be further configured to convert an electrical signal (audio data) into a sound, for example, convert audio data output by the processor 302 into a sound. The audio data output by the processor 302 may be detected by the Bluetooth (BT) communication processing module 304.

In some implementations, the processor 302 may implement a host in a Bluetooth protocol framework, the Bluetooth (BT) communication processing module 304 may implement a controller in the Bluetooth protocol framework, and the host and the controller communicate with each other through an HCI. That is, functions of the Bluetooth protocol framework are distributed on two chips.

In some other embodiments, the processor 302 may implement a host and a controller in the Bluetooth protocol framework. That is, all functions of the Bluetooth protocol framework are placed on a same chip. That is, the host and the controller are placed on the same chip. Because the host and the controller are placed on the same chip, a physical HCI is unnecessary, and the host and the controller directly interact with each other through an application programming interface API.

In other embodiments, different types of audio output devices 300 may include bone conduction sensors, such as bone conduction headphones, for outputting audio signals.

It may be understood that the structure shown in FIG. 3B does not constitute a specific limitation on the audio output device 300. In some other embodiments of this application, the audio output device 300 may include more or fewer components than those shown in the figure, or may combine some components, or may split some components, or may have different component arrangements. The components shown in the figure may be implemented by hardware, software, or a combination of software and hardware.

In this embodiment of the present invention, after obtaining the type information of the earphones 200, the electronic device 100 determines a volume adjustment mode of the earphones 200, so that different types of earphones may have different types of volume adjustment modes, to greatly improve user experience and adapt to different requirements of different types of users.

FIG. 4 is a flowchart of a volume adjustment method according to an embodiment of this application. The method includes the following steps.

Step S401: An electronic device 100 establishes a connection to earphones 200.

Specifically, the electronic device 100 may establish an indirect connection to the earphones 200 in a wired or wireless mode. In the wired mode, the electronic device 100 may establish a connection to the earphones 200 through the earphone jack 170D. In the wireless mode, the electronic device 100 may establish a connection to the earphones 200 through a wireless communication module 160.

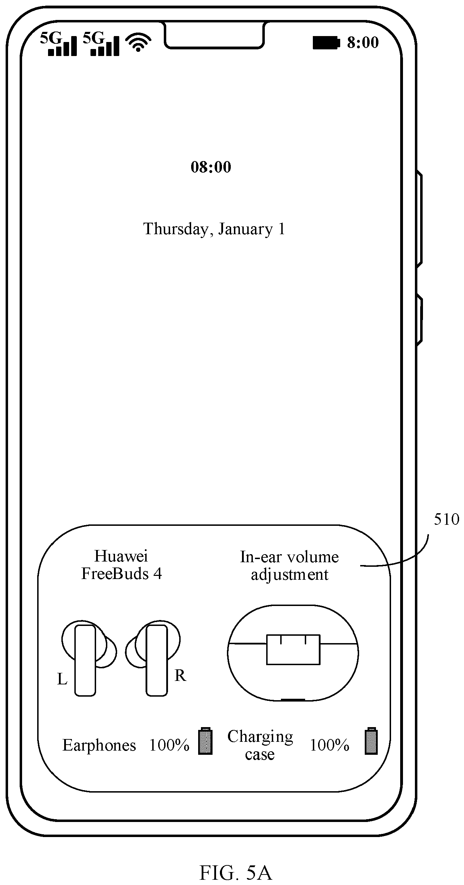

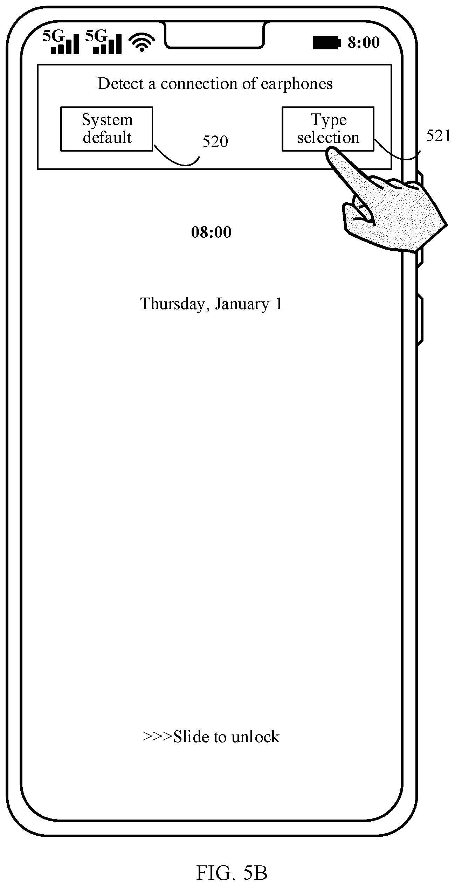

After the electronic device 100 establishes the connection to the earphones 200, prompt information may be displayed in the electronic device 100, for example, in a form of a bottom pop-up window or a top pop-up window, as shown in FIG. 5A and FIG. 5B. Prompt information, for example, a prompt tone such as a beep, may also be played in the earphones 200.

Step S402: The earphones 200 send earphone type information to the electronic device 100.

Specifically, the earphone type information may be an ear hook type, an in-ear type, a head-mounted type, a bone conduction type, and the like that may represent different forms of earphones.

Optionally, in addition to the earphone type information, the earphones 200 may further send the following information to the electronic device 100: earphone manufacturer information, model information, sound generation principle information (a moving coil or a moving iron), earphone processor information, and earphone noise reduction capability information (with a noise reduction capability or without a noise reduction capability), ambient volume, and the like. All the foregoing information may be used as parameters for determining a volume adjustment mode in step S403.

Optionally, in step S401, when the electronic device 100 establishes the wired or wireless connection to the earphones 200, the earphones 200 may simultaneously send the earphone type information to the electronic device 100.

Optionally, step S402 may be replaced with: The electronic device 100 obtains earphone type information entered by a user. Specifically, after the earphones establish the connection to the electronic device, the user actively enters information about the electronic device in the electronic device 100.

For example, for a prompt manner using a bottom pop-up window in FIG. 5A, in FIG. 5A, default detected earphone type information is: "In-ear volume adjustment". The user may perform selection by using a button 510. A specific selection manner may include sliding up and down, submenu selection, and the like. This is not limited herein. For a manner using a top pop-up window in FIG. 5B, an earphone type may be selected by clicking a button 521. A specific selection manner may include sliding up and down, submenu selection, and the like. This is not limited herein.

Step S403: The electronic device determines the volume adjustment mode based on the earphone type information.

For different types of earphones, the electronic device 100 may determine different volume adjustment modes. The following describes a system default volume adjustment mode and a customized mode.

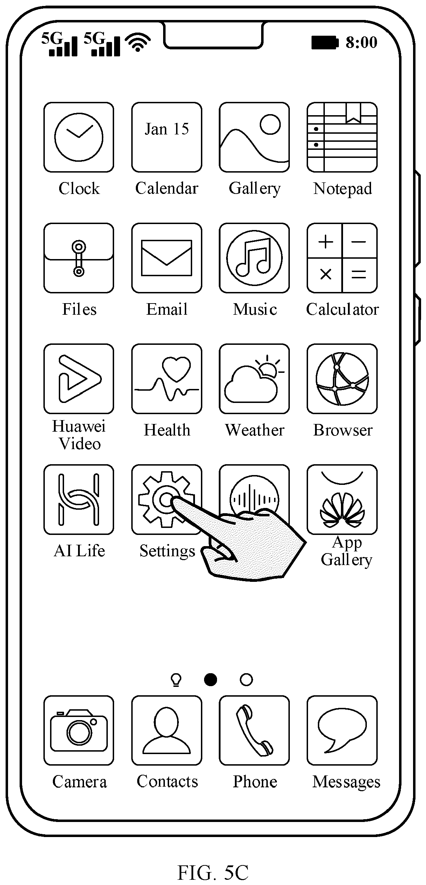

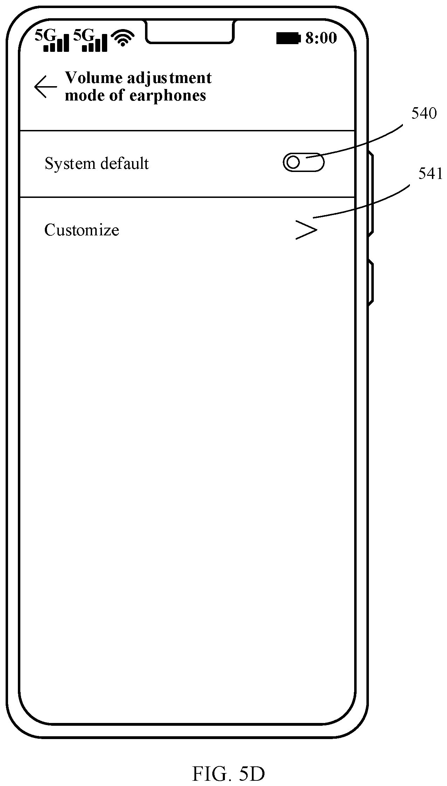

The system default volume adjustment mode is as follows: As shown in FIG. 5C, after the user taps settings on a home screen, the user searches the settings for a setting item of an earphone volume adjustment mode, and then selects a "System default" option 540 in FIG. 5D. For the system default mode, the following mode may be used. For the user, the earphone volume adjustment mode is related to a form of the earphones. For a volume adjustment mode in a related technology, each time volume is adjusted by one level, volume change magnitude perceived by the user is increased in the following sequence: an in-ear type > a head-mounted type > an ear hook type > a bone conduction type. Therefore, the volume of each level may be sequentially increased based on the foregoing arrangement form.

For example, when the electronic device obtains that the earphone type is the in-ear type, maximum volume supported by the electronic device 100 is divided into 100 equal parts, and each time the volume is adjusted by one level on the electronic device, a volume change is 1/100 of the maximum volume. When the electronic device obtains that the earphone type is the head-mounted type, maximum volume is divided into 50 equal parts, and each time the volume is adjusted by one level on the electronic device, a volume change is 1/50 of the maximum volume. When the electronic device obtains that the earphone type is the ear hook type, maximum volume is divided into 20 equal parts, and each time the volume is adjusted by one level on the electronic device, a volume change is 1/20 of the maximum volume. When the electronic device obtains that the earphone type is the bone conduction type, maximum volume is divided into 10 equal parts, and each time the volume is adjusted by one level on the electronic device, a volume change is 1/10 of an upper volume limit.

Optionally, to improve user experience, in the foregoing example, the volume may not correspond to a quantity of adjustment levels in an equal division manner. For example, for earphones with a good noise reduction effect, because the user is less sensitive to a change of high volume than a change of low volume, a proportion of volume corresponding to each level of the high volume to maximum volume may be set to be greater than a proportion of volume corresponding to each level of the low volume to the maximum volume. For example, the maximum volume is adjusted by three levels. When the volume level is changed from 0 to 1, the volume is increased by 1/8 of the maximum volume. When the volume level is changed from 1 to 2, the volume is increased by 1/4 of the maximum volume compared with that when the volume level is changed from 0 to 1. When the volume level is changed from 2 to 3, the volume is increased by 5/8 of the maximum volume. On the contrary, for earphones with a poor noise reduction effect, a proportion of volume corresponding to each level of the low volume to maximum volume may be set to be greater than a proportion of volume corresponding to each level of the high volume to the maximum volume.

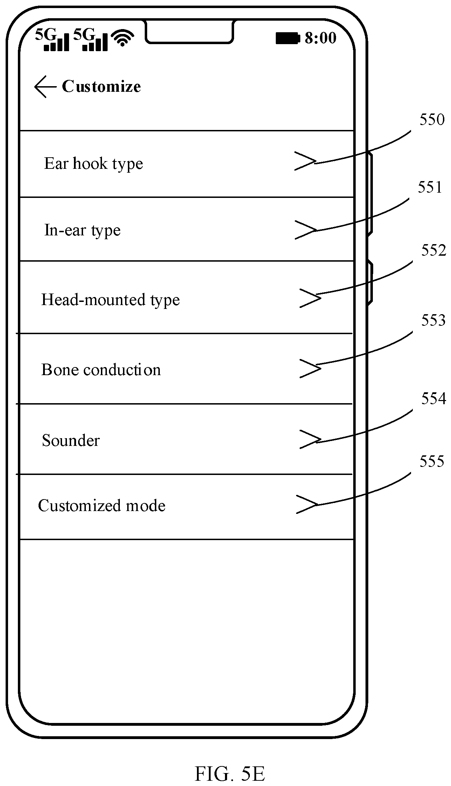

The customized volume adjustment mode is as follows: To improve user experience and user flexibility, this embodiment of this application provides the customized volume adjustment mode. The user may set different volume adjustment modes for different earphone types. For example, in FIG. 5C, after the user taps settings on the home screen, the user searches the settings for a setting item of the earphones volume adjustment mode. Then, in FIG. 5D, the user taps a "Customize" option 541 to enter a setting interface in FIG. 5E. In FIG. 5E, a plurality of types of earphone devices 550 to 553 are included and correspond to ear hook headphones, in-ear earphones, headphones, and bone conduction headphones. In consideration of other audio playback forms of a mobile phone, FIG. 5E further provides a sounder 554 and a customized mode 555. The user taps any option in 550 to 555 on a "Customize" interface of the electronic device 100 in FIG. 5E, and the electronic device 100 jumps to a corresponding setting interface.

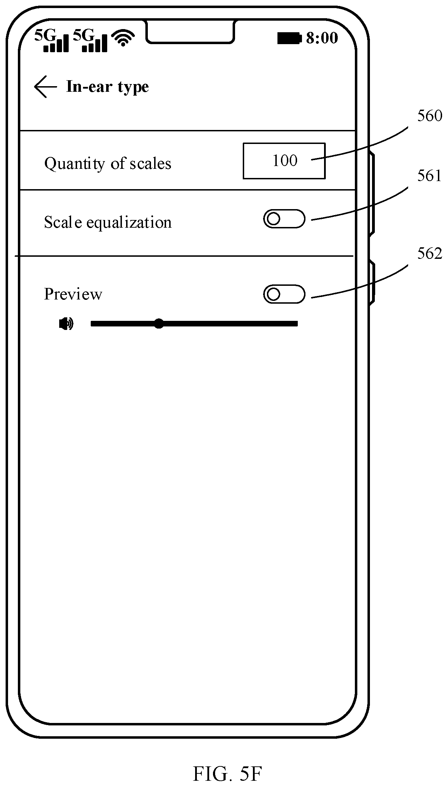

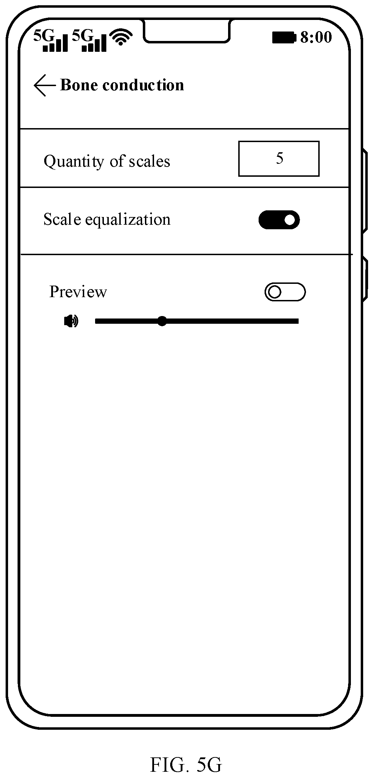

FIG. 5F and FIG. 5G are used as examples. After the in-ear type 551 is tapped in FIG. 5E, the electronic device 100 displays an interface in FIG. 5F, and a quantity of scales may be adjusted in FIG. 5F. The quantity of scales indicates a quantity of parts into which the maximum volume is divided. To be specific, a proportion of volume corresponding to each level to the maximum volume is adjusted by the user through a volume adjustment operation. For the in-ear earphones, the maximum volume supported by the electronic device 100 is divided into 100 equal parts by default. The user may adjust the quantity of scales by inputting or sliding up and down 560. The electronic device divides the supported maximum volume into parts whose quantity is the same as the quantity of scales based on a requirement of the user. The user may adjust the volume corresponding to each scale by using a button 561. For details, refer to the manner provided in the system default volume adjustment mode. Details are not described herein again. To improve user experience, after the user sets 560 and 561, the user may tap a "Preview" button 562, the electronic device plays a piece of music, and the user may adjust the volume by using the volume adjustment button and perform previewing. It should be noted that the electronic device 100 may prompt the user to use corresponding earphones to achieve best experience. FIG. 5G is an interface after the bone conduction type 553 is tapped in FIG. 5E. Different from the interface in FIG. 5F, a default quantity of scales of the bone conduction headphones is less than a default quantity of scales of the in-ear earphones in FIG. 5F. For example, the default quantity of scales of the bone conduction headphones is 5, and the user may perform customized adjustment. For details, refer to the descriptions in FIG. 5F. Details are not described herein again.

Optionally, after determining the volume adjustment mode, the electronic device 100 determines different initial volume for earphones of different earphone types. For example, initial volume for the in-ear type, the head-mounted type, the ear hook type, and the bone conduction type is sequentially increased. Alternatively, an arrangement sequence of the foregoing four types of earphones may be adjusted depending on whether the earphones have a noise reduction function.

Based on a plurality of pieces of information of the earphones in step S402 such as the earphone manufacturer information, the model information, the sound generation principle information (the moving coil or the moving iron), the earphone processor information, the earphone noise reduction capability information (with the noise reduction capability or without the noise reduction capability), and the ambient volume, the volume adjustment mode of the earphones is determined.

For example, the quantity of scales may be further set for the system default mode and the customized mode depending on whether the earphones have a noise reduction function. For the in-ear earphones in FIG. 5F, if a noise reduction mode is enabled, the quantity of scales is greater than that in a normal mode. In this way, the user can adjust volume in more ways, and have better experience. Information indicating whether to enable the noise reduction function may be sent by the earphones 200 to the electronic device 100 through the connection established in step S401, or may be set by the electronic device, and transmitted to the earphones through the connection to the earphones. The noise reduction function may be enabled by the electronic device 100, or may be enabled by the earphones 200. This is not limited herein.

For example, the volume adjustment mode may be further determined based on the ambient volume obtained by the earphones 200 or the electronic device 100. For example, when the ambient volume is high, the quantity of scales is reduced. When the ambient volume is low, the quantity of scales is increased.

Optionally, the electronic device 100 may reduce or increase system default maximum volume based on the earphone type information. For example, if the maximum volume is 100 dB, for the in-ear earphones, the maximum volume of the electronic device is reduced to 50 dB, and for the bone conduction headphones, the maximum volume of the electronic device is increased to 200 dB.

Step S404: The electronic device 100 adjusts the volume based on the volume adjustment mode.

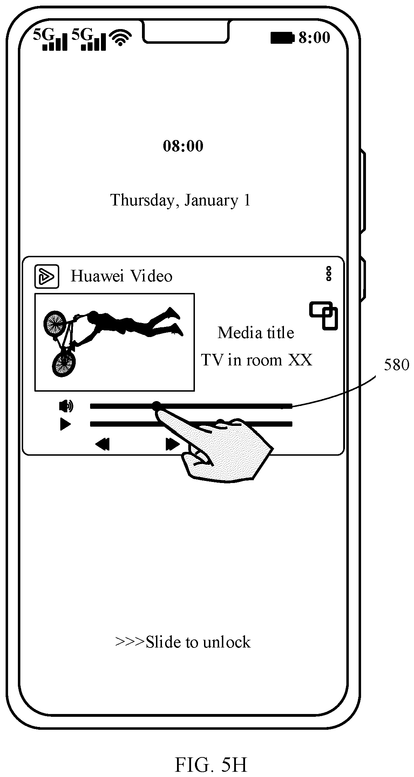

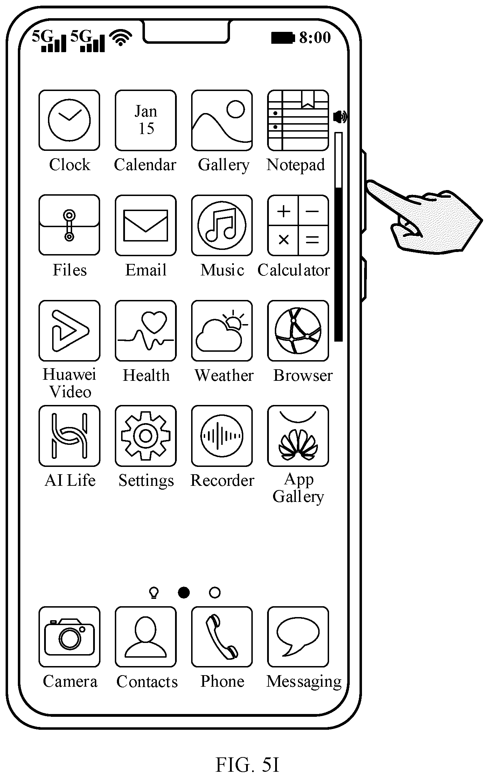

Specifically, the electronic device 100 receives a user operation instruction, and may perform adjustment by using a volume bar on the display, or may perform adjustment by using a volume key on a side frame. For details, refer to FIG. 5H and FIG. 5I. As shown in FIG. 5H, adjustment is performed on a volume bar of a music playback widget on a lock screen. For example, a button on a volume bar 580 is dragged. When the button is dragged, a vibration prompt may be given based on the specified quantity of scales. If the quantity of scales is 5, the electronic device divides the volume bar 580 into five equal parts, and each time the user drags the button forward by several equal parts, the electronic device vibrates for a corresponding quantity of times, so that the user can learn of a volume adjustment amount. As shown in FIG. 5I, the user may adjust a sound by using the volume key on the side frame. Each time the volume key is pressed, a scale is adjusted. When the volume key is pressed, a prompt, for example, a vibration prompt, may be given to the user. Each time the volume key is pressed, the electronic device 100 gives a vibration prompt. If the user long presses the volume key, the volume is increased continuously by a plurality of levels, and a plurality of continuous vibration prompts are given.

Optionally, for different applications, adjustment may be performed in different volume adjustment modes. For example, for a music application, adjustment is performed in the mode in this embodiment, and system volume is adjusted in the default mode in the related technology.

Optionally, step S404 may be replaced with: The electronic device 100 obtains a volume adjustment instruction of the earphones 200, and performs adjustment based on the volume adjustment mode determined in step S403. In addition, the electronic device 100 may obtain a volume adjustment instruction of another distributed device connected to the electronic device 100, and perform adjustment based on the volume adjustment mode determined in step S403.

Step S405: The electronic device 100 transmits an audio corresponding to the volume to the earphones 200, and the earphones 200 play the audio.

The electronic device transmits audio data corresponding to different volume to the earphones 200 in a wired or wireless mode, and the earphones play the audio data.

After the earphones 200 are disconnected from the electronic device 100, the electronic device may stop playing the audio or continue to play the audio by using a speaker of the electronic device. This is not limited herein.

Optionally, in step S402, the earphones 200 may send other information of the earphones, for example, the manufacturer information, the model information, the sound generation principle information (the moving coil or the moving iron), the earphone processor information, and the earphone noise reduction capability information (with the noise reduction capability or without the noise reduction capability) of the earphones, to the electronic device 100 without sending the earphone type information. In step S403, the volume adjustment mode is determined based on the foregoing information. The customized mode or the system default mode may be used. For details, refer to the descriptions in step S403. This is not limited herein. Optionally, the foregoing information may be manually entered by the user on a side of the electronic device 100, as the customized adjustment mode.

For example, two different volume adjustment modes may be set for the electronic device for enabling and disabling of the noise reduction mode. After the user enables the noise reduction mode on the earphones or the mobile phone, the volume adjustment mode is switched. For example, a quantity of scales when the noise reduction mode is disabled is less than a quantity of scales of the earphones when the noise reduction mode is enabled.

For example, different volume adjustment modes may be determined for the ambient volume. For example, when the volume is less than first ambient volume, a first adjustment mode is used; or when the volume is greater than or equal to first ambient volume, a second adjustment mode is used, where a quantity of scales in the second adjustment mode is less than that in the first adjustment mode.

It should be noted that the electronic device 100 may determine the earphone type information based on a part or all of the foregoing information, for example, may determine the earphone type information based on the earphone model information and the manufacturer information.

Step S401 to step S405 described above may be repeatedly performed. For example, after step S401 to step S405 are performed by using first-type earphones, the electronic device adjusts volume of the first-type earphones in a volume adjustment mode corresponding to the first-type earphones. After the first-type earphones are disconnected from the electronic device 100, the electronic device is connected to another type of earphones, for example, second-type earphones. After the electronic device 100 performs step S401 to step S405, the electronic device adjusts volume of the second-type earphones in a volume adjustment mode corresponding to the second-type earphones. Alternatively, after step S401 to step S405 are performed based on the earphone type information, step S401 to step S405 are performed based on another mode, for example, depending on whether the noise reduction mode is enabled.

In conclusion, in this embodiment of the present invention, after obtaining the earphone type information, the electronic device may determine different volume adjustment modes based on different earphone type information, so that the user can adjust volume at different granularities based on a requirement, to improve user experience and protect hearing of the user.

An embodiment of the present invention further includes a computer-readable storage medium. The computer-readable storage medium includes instructions. When the instructions are run on one or more computers, the one or more computers are enabled to perform the method performed by the electronic device or the earphones in FIG. 4.

According to a seventh aspect, a computer program product including instructions is provided. When the computer program product runs on one or more computers, the one or more computers are enabled to perform the method performed by the electronic device or the earphones in FIG. 4.

It should be understood that terms "first", "second", and the like in the specification, the claims, and the accompanying drawings of this application are intended to distinguish between different objects, but are not intended to describe a specific order. In addition, terms such as "including" and "having" and any other variants thereof are intended to cover a non-exclusive inclusion. For example, a process, a method, a system, a product, or a device that include a series of steps or units is not limited to the listed steps or units, but optionally further includes steps or units that are not listed, or optionally further includes other steps or units inherent to these processes, methods, products, or devices.

"An embodiment" mentioned in the present invention indicates that a particular characteristic, structure, or property described with reference to embodiments may be included in at least one embodiment. The phrase appearing at various locations in this specification may neither necessarily mean a same embodiment, nor mean an independent or optional embodiment exclusive from another embodiment. It is explicitly and implicitly understood by a person skilled in the art that embodiments described in the present invention may be combined with other embodiments.

In addition, it should be pointed out herein that an embodiment of the present invention further provides a computer storage medium. The computer storage medium stores a computer program to be executed by the foregoing target detection apparatus. The computer program includes program instructions. When executing the program instructions, the processor can perform the target detection method described above. Therefore, details are not described herein again. In addition, beneficial effects of using a same method are not described in detail again. For technical details that are not disclosed in the embodiment of the computer storage medium in the present invention, refer to the descriptions of the method embodiment of the present invention.

A person of ordinary skill in the art may understand that all or some of the processes of the methods in embodiments may be implemented by a computer program instructing relevant hardware. The program may be stored in a computer-readable storage medium. When the program is executed, the processes of the methods in embodiments are performed. The storage medium may be a magnetic disk, an optical disk, a read-only memory (Read-Only Memory, ROM), a random access memory (Random Access Memory, RAM), or the like.

What are disclosed above are merely example embodiments of the present invention, and certainly are not intended to limit the scope of the claims of the present invention. Therefore, equivalent variations made in accordance with the claims of the present invention shall fall within the scope of the present invention.

## Claims

1. A volume adjustment method, applied to an electronic device, and comprising:
establishing a connection to an audio output device;
obtaining type information of the audio output device;
determining a volume adjustment mode based on the type information of the audio output device;
receiving a volume adjustment instruction operation;
adjusting volume of a to-be-played audio based on the volume adjustment mode and the volume adjustment instruction operation; and
sending the audio to the audio output device.

2. The method according to claim 1, wherein the obtaining type information of the audio output device is specifically: receiving the type information of the audio output device from the audio output device; or
receiving a first input operation, wherein the first input operation comprises the type information of the audio output device.

3. The method according to claim 1, wherein the obtaining type information of the audio output device is specifically:
obtaining a product model of the audio output device; and
obtaining the type information of the audio output device based on the product model of the audio output device.

4. The method according to claim 1, wherein the obtaining type information of the audio output device, and the determining a volume adjustment mode based on the type information of the audio output device are specifically:
obtaining the type information of the audio output device and noise reduction information; and determining the volume adjustment mode based on the type information of the audio output device and the noise reduction information, wherein the noise reduction information indicates whether the audio output device enables a noise reduction function.

5. The method according to claim 1, wherein the volume adjustment mode is a system default mode or a customized volume adjustment mode.

6. The method according to claim 1, wherein after the obtaining type information of the audio output device, the method further comprises outputting the type information of the device by using a pop-up window on an interface.

7. The method according to any one of claims 1 to 6, wherein in the volume adjustment mode, each of a plurality of scales corresponds to different volume.

8. The method according to any one of claims 1 to 8, wherein the audio output device is specifically any one of headphones, in-ear earphones, ear hook headphones, bone conduction headphones, or a sounder.

9. A volume adjustment method, applied to an audio output device, and comprising:
establishing a connection to an electronic device;
sending type information of the audio output device to the electronic device;
receiving an audio sent by the electronic device, wherein the audio is determined by the electronic device based on the type information of the audio output device; and
playing the audio.

10. The method according to claim 9, wherein the sending type information of the audio output device to the electronic device, and the receiving an audio sent by the electronic device, wherein the audio is determined by the electronic device based on the type information of the audio output device, are specifically:
sending the type information of the audio output device and noise reduction information to the electronic device, wherein the noise reduction information indicates whether the audio output device enables a noise reduction function; and
receiving the audio sent by the electronic device, wherein the audio is determined by the electronic device based on the type information of the audio output device and the noise reduction information.

11. The method according to claim 9 or 10, wherein the audio output device is specifically any one of headphones, in-ear earphones, ear hook headphones, bone conduction headphones, or a sounder.

12. A volume adjustment method, applied to a system comprising an audio output device and an electronic device, wherein
the electronic device establishes a connection to the audio output device;
the electronic device obtains type information of the audio output device;
the electronic device determines a volume adjustment mode based on the type information of the audio output device;
the electronic device receives a volume adjustment instruction operation;
the electronic device adjusts volume of a to-be-played audio based on the volume adjustment mode and the volume adjustment instruction operation;
the electronic device sends the audio to the audio output device; and
the audio output device plays the audio.

13. An electronic device, comprising a processor, wherein the processor performs the method according to any one of claims 1 to 8 by running code in a memory.

14. An audio output device, comprising a processor, wherein the processor performs the method according to any one of claims 9 to 11 by running code in a memory.

15. A computer-readable storage medium, comprising instructions, wherein when the instructions are run on one or more computers, the one or more computers are enabled to perform the method according to any one of claims 1 to 11.
